## Europäisches Patentamt
## European Patent Office
## Office européen des brevets

(19)

(11) Veröffentlichungsnummer: **0 134 571 B1**

(12)

# EUROPÄISCHE PATENTSCHRIFT

(45) Veröffentlichungstag der Patentschrift:
**07.01.88**

(51) Int. Cl.⁴: **H 01 L 23/52**, H 01 L 21/90

(21) Anmeldenummer: **84110189.2**

(22) Anmeldetag: **27.08.84**

(54) **Integrierte Halbleiterschaltung mit einer aus Aluminium oder aus einer Aluminium-Legierung bestehenden Mehrlagenverdrahtung und Verfahren zu ihrer Herstellung.**

(30) Priorität: **02.09.83 DE 3331759**

(43) Veröffentlichungstag der Anmeldung:
**20.03.85 Patentblatt 85/12**

(45) Bekanntmachung des Hinweises auf die Patenterteilung:
**07.01.88 Patentblatt 88/1**

(84) Benannte Vertragsstaaten:
**AT BE DE FR GB IT NL SE**

(56) Entgegenhaltungen:
**EP - A - 0 013 728**
**EP - A - 0 072 522**
**DE - A - 3 027 954**
**US - A - 4 107 726**

(73) Patentinhaber: **Siemens Aktiengesellschaft Berlin und München, Wittelsbacherplatz 2, D-8000 München 2 (DE)**

(72) Erfinder: **Neppl, Franz, Dr. rer. nat., St.-Quirin-Platz 6, D-8000 München 90 (DE)**
Erfinder: **Schwabe, Ulrich, Dr., Plievierpark 14, D-8000 München 83 (DE)**

## Beschreibung

Verfahren zum Herstellen einer integrierten Halbleiterschaltung mit einer aus Aluminium oder aus einer Aluminium-Legierung bestehenden Mehrlagenverdrahtung.

Die vorliegende Patentanmeldung betrifft ein Verfahren zum Herstellen einer integrierten Halbleiterschaltung mit aus Aluminium oder aus einer Aluminium-Legierung bestehenden, in mindestens zwei Ebenen liegenden Kontaktleiterbahnen (Mehrlagenverdrahtung), die durch Isolationsschichten getrennt und durch in die Isolationsschichten eingebrachte Kontaktlöcher (via holes) elektrisch miteinander verbunden sind.

Die minimal möglichen Metallraster bei Zwei-Lagen-Verdrahtung sind abgesehen von Foto- und Ätztechnik durch die nötigen Sicherheitsabstände a und b in lateraler Richtung beim Kontaktloch (via hole) bestimmt. Mit fortschreitender Verkleinerung dieser via holes wird ausserdem die ausreichende Kantenbedeckung der zweiten Metallebene im Kontaktloch problematisch (es ergeben sich Einschnürungen c der Metallbahn im Kontaktloch).

Wie aus der DE-A-2 642 471 zu entnehmen ist, kann der Sicherheitsabstand b bei geeigneter Wahl der ersten und zweiten Isolationsschichten sowie des Ätzverfahrens für die Einbringung der via holes dadurch entfallen, dass die via holes überlappend ausgebildet werden. Voraussetzung dafür ist ein guter Ätzstop der via hole-Ätzung auf der zweiten Isolationsschicht. In diesem Fall kann das die erste Kontaktleiterbahnebene bildende Aluminium-I-Raster bei gleicher Foto- und Ätztechnik um den Sicherheitsabstand 2b reduziert werden. Der Sicherheitsabstand a muss aber nach wie vor eingehalten werden, da sonst beim vermeidlichen Überziehen der Ätzung für das Aluminium-II-Raster eine Schwächung des Aluminium-I-Querschnittes auftritt, die zu Aluminium-I-Unterbrechungen führen kann.

Aus einem Aufsatz von L.B. Rothman im Journ. of Electrochem. Soc., Vol 130, Nr. 5 (1983), Seiten 1131 bis 1136 ist zu entnehmen, dass das Kantenbedeckungsproblem durch Auffüllen von via holes mit Aluminium oder Aluminium-Legierungen in den Kontakten verringert werden kann. Diese Technologie ist aber wegen der Verwendung von Abhebetechniken sehr aufwendig und verwendet Polyimide, deren MOS-Kompatibilität nicht gesichert ist.

Der Erfindung liegt die Aufgabe zugrunde, bei einer integrierten Halbleiterschaltung mit einem auf Aluminium basierenden Metallisierungssystem neben dem Problem der Kantenbedeckung der zweiten Metallebene im Kontakt auch das Problem der Sicherheitsabstände im Bereich des Kontaktloches bei fortschreitender Miniaturisierung in der VLSI-Technik zu lösen.

Diese Lösung erfolgt erfindungsgemäss durch ein Verfahren der eingangs genannten Art dadurch, dass
a) im Anschluss an die Ätzung der Kontaktlöcher in die die erste Leiterbahnebene bedeckende erste Isolationsschicht (4) in den Kontaktlöchern durch selektive Abscheidung aus der Gasphase ein Nicht-Aluminium-Metall in der Dicke der ersten Isolationsschicht aufgebracht wird,
b) dass dann ganzflächig die die zweite Leiterbahnebene bildende Aluminium- oder Aluminium-Legierungsschicht abgeschieden wird und
c) die zweite Leiterbahnebene unter Verwendung eines nasschemischen Ätzprozesses, in welchem sich das Nicht-Aluminium-Metall weitgehend resistent verhält, strukturiert wird.

Weitere Ausgestaltungen der Erfindung ergeben sich aus den Unteransprüchen.

Im folgenden wird anhand der in der Zeichnung befindlichen Fig. 1 bis 6 die Erfindung noch näher erläutert. Dabei zeigen

die Fig. 1 und 2 anhand eines Schnittbildes und einer Draufsicht einer bekannten Struktur die Probleme, die durch das erfindungsgemässe Verfahren gelöst werden,
die Fig. 3 und 4 im Schnittbild die erfindungswesentlichen Schritte zur Herstellung einer Zweilagenverdrahtung,
die Fig. 5 und 6 die Fig. 4 in Draufsicht.

Für gleiche Teile gelten in allen Figuren gleiche Bezugszeichen.

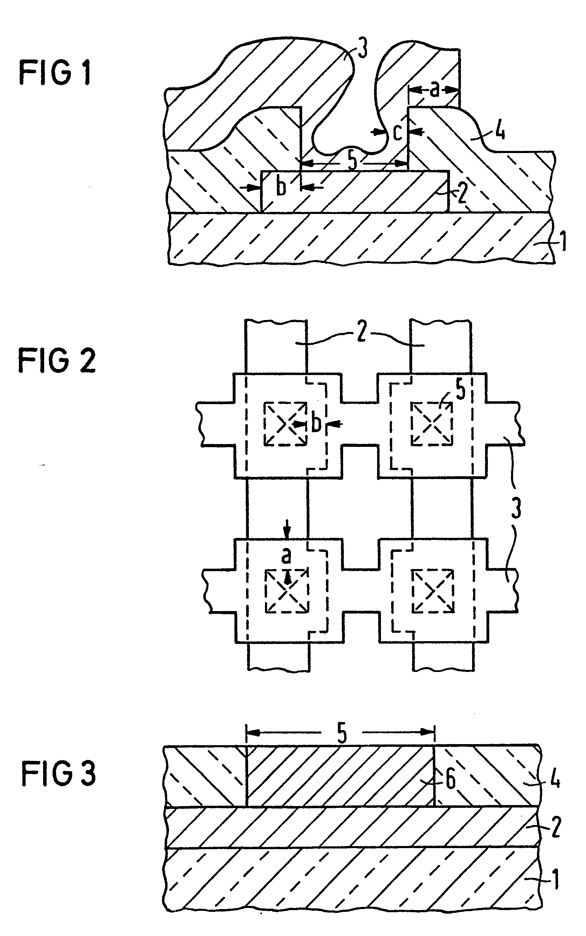

Die Fig. 1 und 2 zeigen wie die minimal möglichen Metallraster bei Zweilagenverdrahtung (2, 3) durch die notwendigen Sicherheitsabstände a und b beim via hole (5) bestimmt sind. Mit dem Bezugszeichen 1 ist die unter der ersten Aluminium-Leiterbahnebene 2 befindliche Isolationsschicht, mit 3 die zweite Aluminium-Leiterbahnebene und mit 4 die erste Isolationsschicht bezeichnet. Wie aus der Fig. 1 ersichtlich ist, wird durch die Einschnürung c eine ausreichende Kantenbedeckung der zweiten Aluminium-Leiterbahnebene 3 im Kontaktloch 5 problematisch.

Beim erfindungsgemässen Verfahren, bei dem einerseits die via holes 5 aufgefüllt werden und gleichzeitig der Sicherheitsabstand a entfallen kann, wird wie folgt vorgegangen:

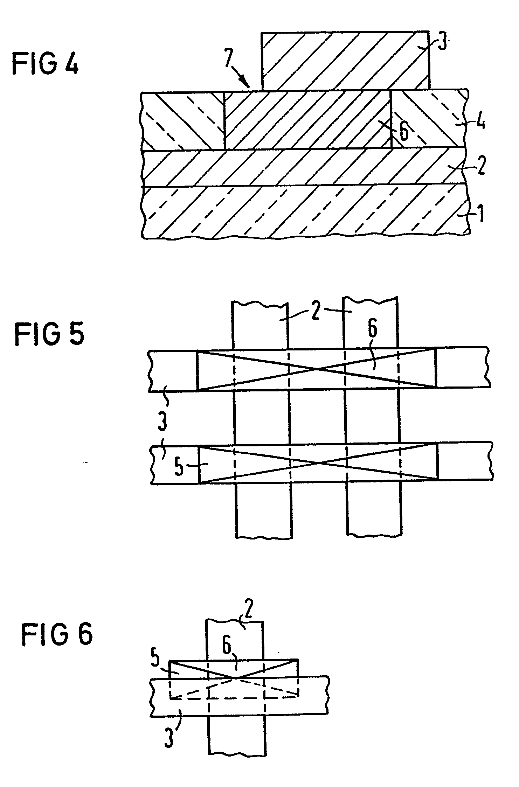

Fig. 3 und 4: Nach der in bekannter Weise durchgeführten Kontaktlochätzung wird in den Kontaktlöchern 5 durch selektive Abscheidung aus der Gasphase (CVD-Verfahren) Tantalsilizid 6 in der Dicke der ersten Isolationsschicht 4 selektiv aufgebracht. Dies geschieht beispielsweise durch thermische Zersetzung eines Gasgemisches, bestehend aus Tantalchlorid, Wasserstoff und Dichlorsilan ($SiH_2Cl_2$) im Verhältnis 1:10:2 bei einem Druck von 133 Pa und einer Abscheidetemperatur von 850°C. Durch Einstellung dieser Werte wird erreicht, dass sich genügend Chlorwasserstoff abspaltet, um die Keimbildung für eine Tantalsilizid-Abscheidung auf den nicht aus Aluminium bestehenden Bereichen zu unterdrükken. Damit ist das via hole gefüllt und das Kantenbedeckungsproblem für die nachfolgende Abscheidung der zweiten Aluminium-Leiterbahnebene 3 eliminiert. Die Verwendung eines Nicht-Aluminium-Metalles 6 wie Wolfram oder Tantalsilizid gewährleistet bei der Strukturierung der zweiten Aluminium-Leiterbahnebene 3, welche zum Beispiel durch nasschemische Ätzung in einem Gemisch von Phosphorsäure, Salpetersäure und Wasser im Verhältnis 20:1:4 bei 40°C vorgenommen wird, einen guten Ätzstop (siehe Pfeil 7 in Fig. 4), so dass auf den Sicherheitsabstand a verzichtet werden kann.

Wie aus Fig. 5 zu entnehmen ist, kann daher das Raster der zweiten Aluminium-Kontaktleiterbahnebene 3 um den Betrag 2a reduziert werden.

Die Fig. 6 zeigt in einem Ausschnitt aus Fig. 5 wie trotz einer Verjustierung der zweiten Aluminium-Leiterbahnebene 3, bezüglich der via hole-Ebene (5), bedingt durch den guten Ätzstop 7, das Aluminium der ersten Leiterbahnebene geschützt bleibt.

Sinngemäss lässt sich das erfindungsgemässe Verfahren mit den gleichen Vorzügen auch auf Mehrlagen-Verdrahtungen und andere Verdrahtungsebenen-Kombinationen wie zum Beispiel Verbindungen von Aluminium-Leiterbahnen zur Polysilizium und Diffusionsgebieten aus einkristallinem Silizium anwenden. Hierbei ist vorteilhaft, dass neben den niedrigen Übergangswiderständen zu Aluminium Tantalsilizid oder Wolfram gleichzeitig als Barriere gegen Kontaktreaktionen zwischen Aluminium und Silizium (zum Beispiel «spiking») wirkt.

## Patentansprüche

1. Verfahren zum Herstellen einer integrierten Halbleiterschaltung mit aus Aluminium oder aus einer Aluminium-Legierung bestehenden, in mindestens zwei Ebenen liegenden Kontaktleiterbahnen (2, 3) (Mehrlagenverdrahtung), die durch Isolationsschichten (4) getrennt und durch in die Isolationsschichten (4) eingebrachte Kontaktlöcher (5) (via holes) elektrisch miteinander verbunden sind, dadurch gekennzeichnet, dass

a) Im Anschluss an die Ätzung der Kontaktlöcher (5) in die die erste Leiterbahnebene (2) bedeckende erste Isolationsschicht (4) in den Kontaktlöchern (5) durch selektive Abscheidung aus der Gasphase ein Nicht-Aluminium-Metall (6) in der Dicke der ersten Isolationsschicht (4) aufgebracht wird,

b) dass dann ganzflächig die die zweite Leiterbahnebene (3) bildende Aluminium- oder Aluminium-Legierungsschicht abgeschieden wird und

c) die zweite Leiterbahnebene (3) unter Verwendung eines nasschemischen Ätzprozesses, in welchem sich das Nicht-Aluminium-Metall (6) weitgehend resistent verhält, strukturiert wird.

2. Verfahren nach Anspruch 1, dadurch gekennzeichnet, dass als Ätzmittel nach Verfahrensschritt c) ein Gemisch aus Phosphorsäure (85%ig), Salpetersäure (65%ig) und Wasser im Verhältnis 20:1:4 verwendet wird und der Ätzprozess bei 40°C durchgeführt wird.

3. Verfahren nach Anspruch 1 und 2, dadurch gekennzeichnet, dass als Nicht-Aluminium-Metall (6) hochschmelzende Metalle, vorzugsweise Wolfram verwendet wird.

4. Verfahren nach Anspruch 1 und 2, dadurch gekennzeichnet, dass als Nicht-Aluminium-Metall (6) Silizide hochschmelzender Metalle, vorzugsweise Tantalsilizid, verwendet wird.

5. Verfahren nach Anspruch 1 bis 4, dadurch gekennzeichnet, dass die selektive Abscheidung (6) nach Verfahrensschritt a) unter Verwendung eines bei der Reaktion Halogenwasserstoff abspaltenden Reaktionsgases durchgeführt wird.

6. Verfahren nach Anspruch 5, dadurch gekennzeichnet, dass als Reaktionsgas ein Gemisch aus Tantalchlorid ($TaCl_5$), Wasserstoff und einer halogenierten Silanverbindung bzw. Wolframfluorid ($WF_6$) und Wasserstoff verwendet wird.

## Claims

1. A process for the production of an integrated semiconductor circuit having contact conductor paths (2, 3) consisting of aluminium or an aluminium alloy and arranged in at least two planes (multi-layer wiring), which are separated by insulating layers (4) and which are electrically connected to one another by way of contact holes (5) (via holes) introduced into the insulating layers (4), characterised in that

a) after the etching of the contact holes (5) into the first insulating layer (4) which covers the first conductor path plane (2), a non-aluminium metal (6), whose thickness is equal to that of the first insulating layer (4), is applied in the contact holes (5) by selective deposition from the gas phase,

b) that the aluminium or aluminium-alloy layer which forms the second conductor path plane is then deposited onto the entire surface, and

c) the second conductor path plane (3) is structured using a wet-chemical etching process to which the non-aluminium metal (6) is largely resistant.

2. A process as claimed in Claim 1, characterised in that the etching agent used in process step c) consists of a mixture of phosphoric acid (85%), nitric acid (65%) and water in a ratio of 20:1:4, and that the etching process is carried out at 40°C.

3. A process as claimed in Claim 1 and 2, characterised in that metals having a high melting point, preferably tungsten, is used as non-aluminium metal (6).

4. A process as claimed in Claim 1 and 2, characterised in that silicides of metals having high melting points, preferably tantalum silicide, are used as non-aluminium metal (6).

5. A process as claimed in Claim 1 to 4, characterised in that the selective deposition (6) in process step a) is carried out using a reaction gas which splits off hydrogen halide during the reaction.

6. A process as claimed in Claim 5, characterised in that a mixture of tantalum chloride ($TaCl_5$), hydrogen and a halogenated silane compound, or tungsten fluoride ($WF_6$) and hydrogen, is used as reaction gas.

## Revendications

1. Procédé pour réaliser un circuit à semiconducteurs intégré avec des pistes conductrices de contact (2, 3) (câblage à couches multiples) situées au moins dans deux plans et constituées par de l'aluminium ou par un alliage d'aluminium, pistes conductrices qui sont séparées par des couches isolantes (4) et qui sont reliées électriquement entre elles par des trous de contact (5) (via holes) ménagés dans les couches isolantes (4), caractérisé par le fait que

a) à la suite de l'attaque pour réaliser les trous de contact (5) dans la première couche isolante (4) qui recouvre le plan de pistes conductrices (2), on dépose dans les trous de contact (5), par un dépôt sélectif, à partir de la phase gazeuse, un métal différent de l'aluminium (6), d'une épaisseur égale à la première couche isolante (4),

b) on dépose ensuite, et d'un seul tenant, la couche d'aluminium ou la couche d'alliage d'aluminium qui forme le second plan de pistes conductrices, et

c) on structure le second plan de pistes conductrices (3) avec mise en œuvre d'un processus de corrosion par voie humide, dans lequel le métal (6) différent de l'aluminium se comporte de façon largement résistante.

2. Procédé selon la revendication 1, caractérisé par le fait que le produit de corrosion selon la phase opératoire c) est constitué par un mélange d'acide phosphorique (à 85%), d'acide nitrique (à 65%) et d'eau dans le rapport de 20:1:4, et que le processus de corrosion est réalisé à la température de 40°C.

3. Procédé selon la revendication 1 ou 2, caractérisé par le fait que l'on utilise, comme métal différent de l'aluminium (6), des métaux à point de fusion élevé, de préférence du tungstène.

4. Procédé selon la revendication 1 et 2, caractérisé par le fait que l'on utilise, comme métal différent de l'aluminium (6), des siliciures de métaux à point de fusion élevé, de préférence du siliciure de tantale.

5. Procédé selon la revendication 1 à 4, caractérisé par le fait que le dépôt sélectif (6) selon la phase opératoire a) est réalisé avec mise en œuvre d'un gaz réactionnel avec déshydrohalogénation durant la réaction.

6. Procédé selon la revendication 5, caractérisé par le fait que l'on utilise comme gaz réactionnel, un mélange de chlorure de tantale ($TaCl_5$), d'hydrogène et d'un composé halogéné du silane ou du fluorure de tungstène ($WF_6$) et d'hydrogène.

FIG 1

FIG 2

FIG 3

FIG 4

FIG 5

FIG 6